# EUROPEAN PATENT APPLICATION

(11) **EP 4 848 956 A1**
(43) Date of publication of application: **02.12.2026**
(21) Application number: 24941053.1
(22) Date of filing: 29.05.2024
(51) Int. Cl.: H10K 59/12

(54) **DISPLAY PANEL AND MANUFACTURING METHOD THEREFOR, AND DISPLAY DEVICE COMPRISING DISPLAY PANEL**

(71) Applicant: BOE Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Beijing 100176 (CN)
(72) Inventor: SUN, Huaping, Beijing 100176 (CN); ZHANG, Kai, Beijing 100176 (CN); FU, Qiang, Beijing 100176 (CN); CHEN, Yafei, Beijing 100176 (CN); SONG, Erlong, Beijing 100176 (CN); ZHANG, Qi, Beijing 100176 (CN)
(74) Representative: Studio Torta S.p.A.
(86) International application number: PCT/CN2024/096094
(87) International publication number: WO 2025/245741

(57) **Abstract**

The present disclosure provides a display panel, which includes a substrate, a time-varying signal wiring arranged above the substrate, a DC constant signal wiring in a film layer adjacent to the time-varying signal wiring, wherein an orthographic projection of the DC constant signal wiring onto the substrate does not overlap with an orthographic projection of the time-varying signal wiring onto the substrate. In addition, the present disclosure also relates to a display panel manufacturing method for manufacturing the above display panel, and also relates to a display device including the above display panel.

## Description

### TECHNICAL FIELD

The present disclosure relates to the field of display technologies, in particular, to a display panel and a manufacturing method of the display panel, and also to a display device including the display panel.

### BACKGROUND

As organic light emitting diode (i.e. OLED) display panels are constitutively improved in terms of resolution and refresh frequency, their power consumption is also higher and higher. Especially in the laminated structure of current OLED display panels, a metal layer for common ground network wiring is generally arranged adjacent to a film layer where a Gate Driven on Array of an array substrate (i.e. GOA, hereinafter referred to as a GOA circuit), used for driving the OLED display panel, is located. Therefore, there is mutual capacitance between the metal layer where the common ground network wiring is located and the GOA circuit. The presence of the mutual capacitance, on the one hand, results in a significant increase in the power consumption of the GOA circuit and, on the other hand, a significant load on the common ground network.

### SUMMARY

According to a first aspect of the present disclosure, there is provided a display panel, wherein the display panel includes a substrate, a time-varying signal wiring arranged above the substrate, a DC constant signal wiring in a film layer adjacent to the time-varying signal wiring, wherein an orthographic projection of the DC constant signal wiring onto the substrate does not overlap with an orthographic projection of the time-varying signal wiring onto the substrate.

According to some exemplary embodiments, the orthographic projection of the DC constant signal wiring onto the substrate surrounds the orthographic projection of the time-varying signal wiring onto the substrate.

According to some exemplary embodiments, the orthographic projection of the DC constant signal wiring onto the substrate and the orthographic projection of the time-varying signal wiring onto the substrate are offset from each other.

According to some exemplary embodiments, the display panel further includes a GOA circuit arranged on the substrate, wherein the time-varying signal wiring includes a clock signal line providing a clock signal for the GOA circuit, and the DC constant signal wiring includes a common ground network wiring.

According to some exemplary embodiments, the time-varying signal wiring further includes a start signal line providing a start signal for the GOA circuit.

According to some exemplary embodiments, an orthographic projection of the common ground network wiring onto the substrate does not overlap with an orthographic projection of the GOA circuit onto the substrate.

According to some exemplary embodiments, the orthographic projection of the common ground network wiring onto the substrate also surrounds the orthographic projection of the GOA circuit onto the substrate.

According to some exemplary embodiments, the orthographic projection of the common ground network wiring onto the substrate and the orthographic projection of the GOA circuit onto the substrate are also offset from each other.

According to some exemplary embodiments, the orthographic projection of the common ground network wiring onto the substrate covers the orthographic projection of the GOA circuit onto the substrate, wherein a portion of the orthographic projection of the common ground network wiring onto the substrate overlapping with the orthographic projection of the GOA circuit onto the substrate includes a plurality of openings.

According to some exemplary embodiments, the orthographic projection of the common ground network wiring onto the substrate covers the orthographic projection of the GOA circuit onto the substrate, wherein a portion of the orthographic projection of the common ground network wiring onto the substrate overlapping with the orthographic projection of the GOA circuit onto the substrate has a mesh shape.

According to some exemplary embodiments, an orthographic projection bit of the common ground network wiring onto the substrate is covered by an orthographic projection of a display area of the display panel onto the substrate, and orthographic projections of the clock signal line and the GOA circuit onto the substrate do not overlap with the orthographic projection of the display area onto the substrate.

According to some exemplary embodiments, the display panel further includes a common ground network wiring, wherein at least one metal wiring film layer is further provided between a film layer where the common ground network wiring is located and a film layer where the time-varying signal wiring is located, and wherein an orthographic projection of the common ground network wiring onto the substrate does not overlap with an orthographic projection of the time-varying signal wiring onto the substrate.

According to a second aspect of the present disclosure, there is provided a display panel manufacturing method, including: providing a substrate; forming a time-varying signal wiring above the substrate; forming a DC constant signal wiring in a film layer adjacent to the time-varying signal wiring, wherein an orthographic projection of the DC constant signal wiring onto the substrate does not overlap with an orthographic projection of the time-varying signal wiring onto the substrate.

According to some exemplary embodiments, the display panel manufacturing method further including: forming a GOA circuit on the substrate; wherein the time-varying signal wiring includes a clock signal line providing a clock signal for the GOA circuit, and the DC constant signal wiring includes a common ground network wiring.

According to a third aspect of the present disclosure, there is provided a display device, wherein the display device includes the display panel according to the first aspect of the present disclosure and the exemplary embodiments thereof.

According to some exemplary embodiments, the display device is an OLED display device.

### BRIEF DESCRIPTION OF DRAWINGS

Hereinafter, exemplary embodiments of the present disclosure will be described in detail with reference to the accompanying drawings, in which:
FIG. 1 schematically illustrates a display panel in the related art;
FIGs. 2A and 2B schematically illustrate a situation of mutual capacitance existing in a display panel in the related art;
FIGs. 3A and 3B schematically illustrate a structure of a display panel according to an exemplary embodiment of the present disclosure;
FIGs. 4A and 4B schematically illustrate a structure of a display panel according to another exemplary embodiment of the present disclosure;
FIGs. 5A and 5B schematically illustrate a structure of a display panel according to another exemplary embodiment of the present disclosure;
FIGs. 6A and 6B schematically illustrate a structure of a display panel according to another exemplary embodiment of the present disclosure;
FIGs. 7A and 7B schematically illustrate a structure of a display panel according to another exemplary embodiment of the present disclosure;
FIGS. 8A and 8B schematically illustrate a structure of a display panel according to another exemplary embodiment of the present disclosure;
FIG. 9 schematically illustrates a structure of a display panel according to another exemplary embodiment of the present disclosure;
FIG. 10 schematically illustrates a structure of a display panel according to another exemplary embodiment of the present disclosure;
FIG. 11 schematically illustrates a structure of a display panel according to another exemplary embodiment of the present disclosure;
FIG. 12 schematically illustrates a structure of a display panel according to another exemplary embodiment of the present disclosure;
FIG. 13 schematically illustrates structures of various portions in a display panel according to an exemplary embodiment of the present disclosure;
FIG. 14 schematically illustrates, in the form of a flowchart, a display panel manufacturing method according to an exemplary embodiment of the present disclosure; and
FIG. 15 schematically illustrates, in the form of a block diagram, a display device according to an exemplary embodiment of the present disclosure.

It should be understood that the drawings are merely schematic illustrations of exemplary embodiments of the present disclosure, not limitations to the present disclosure. They are not necessarily drawn to scale as well. Furthermore, in the drawings, the same or similar features are indicated with the same or similar reference numerals.

### DETAILED DESCRIPTION

Various exemplary embodiments of the present disclosure are described below in conjunction with the drawings to enable those skilled in the art to fully understand and implement the technical solutions according to the present disclosure.

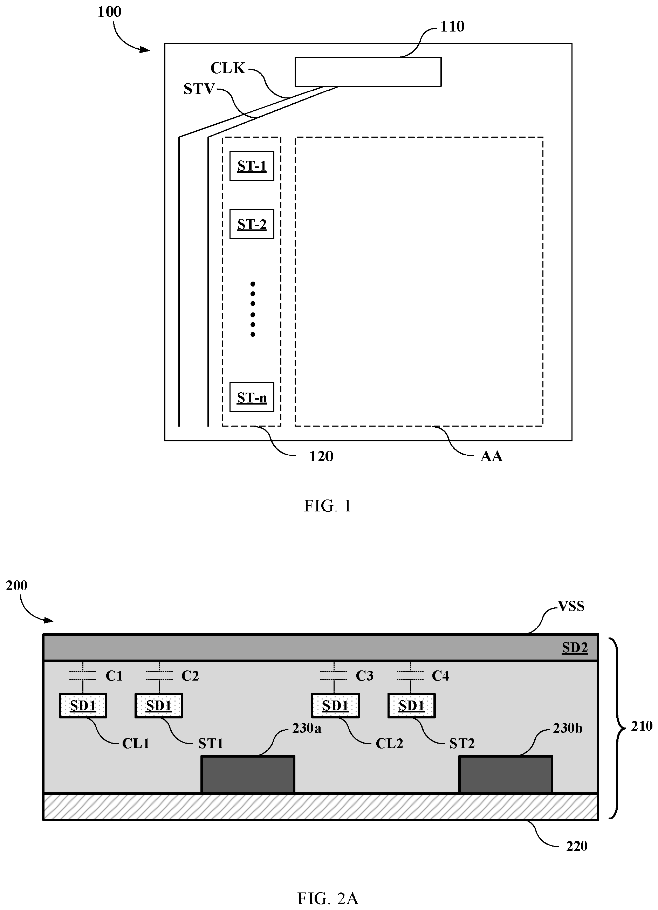

Referring to FIG. 1, a display panel in the related art is schematically illustrated. As shown in FIG. 1, the display panel 100 may be a liquid crystal display panel or an OLED display panel, which may include a display area AA for displaying an image and an edge area surrounding the display area AA. The timing controller 110, the clock signal line CLK, the start signal line STV, and the GOA circuit 120 may be generally provided in the above-described edge area of the display panel 100. The timing controller 110 may generate a clock signal and a start signal necessary for controlling the GOA circuit 120, and may send the clock signal and the start signal to the GOA circuit 120 via the clock signal line CLK and the start signal line STV, respectively. The GOA circuit 120 may include a plurality of gate driving units ST-1, ST-2 to ST-n, each of which is connected to a gate line respectively, so as to drive the display panel 100.

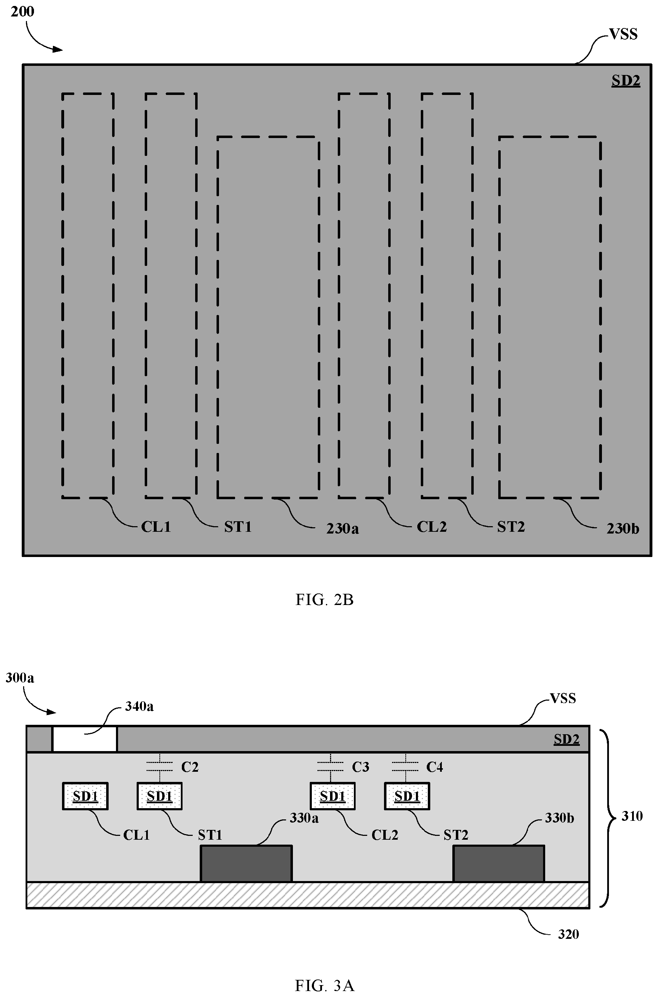

Referring to FIGs. 2A and 2B, a situation of mutual capacitance existing in a display panel in the related art is schematically illustrated, wherein FIG. 2A schematically shows a laminated structure of a portion of the display panel in the related art in the form of a cut-away view, and FIG. 2B schematically shows a top view of the portion of the display panel shown in FIG. 2A in the form of a plan view. As shown in FIG. 2A, the display panel 200 may include a laminated structure 210 including: a substrate 220; GOA circuits 230a, 230b; a clock signal line CL1 providing a clock signal for the GOA circuit 230a and a start signal line ST1 providing a start signal for the GOA circuit 230a, a clock signal line CL2 providing a clock signal for the GOA circuit 230b and a start signal line ST2 providing a start signal for the GOA circuit 230b; and a common ground network wiring VSS. The GOA circuits 230a, 230b may be arranged on the substrate 220, clock signal lines CL1, CL2 and start signal lines ST1, ST2 may be arranged in a first source/drain wiring layer SD1 located above the GOA circuits 230a, 230b, the common ground network wiring VSS may be arranged in a second source/drain wiring layer SD2 adjacent to the first source/drain wiring layer SD1, and as shown in FIG. 2B, the common ground network wiring VSS in the second source/drain wiring layer SD2 covers the clock signal lines CL1, CL2 and the start signal lines ST1, ST2 in the first source/drain wiring layer SD1, and also covers the GOA circuits 230a, 230b. Accordingly, mutual capacitances C1, C2, C3, and C4 are formed between the clock signal lines CL1, CL2 and the start signal lines ST1, ST2 located in the first source/drain wiring layer SD1 and the common ground network wiring VSS located in the second source/drain wiring layer SD2, respectively. The presence of the mutual capacitances C1, C2, C3 and C4 results in time-varying signals, such as clock signals and/or start signals, requiring repeated charging and discharging of these capacitances during transitions between high and low levels, which on the one hand results in a significant increase in the power consumption of the GOA circuits 230a, 230b and, on the other hand significantly increases loads in the DC constant signal wiring such as the common ground network wiring VSS.

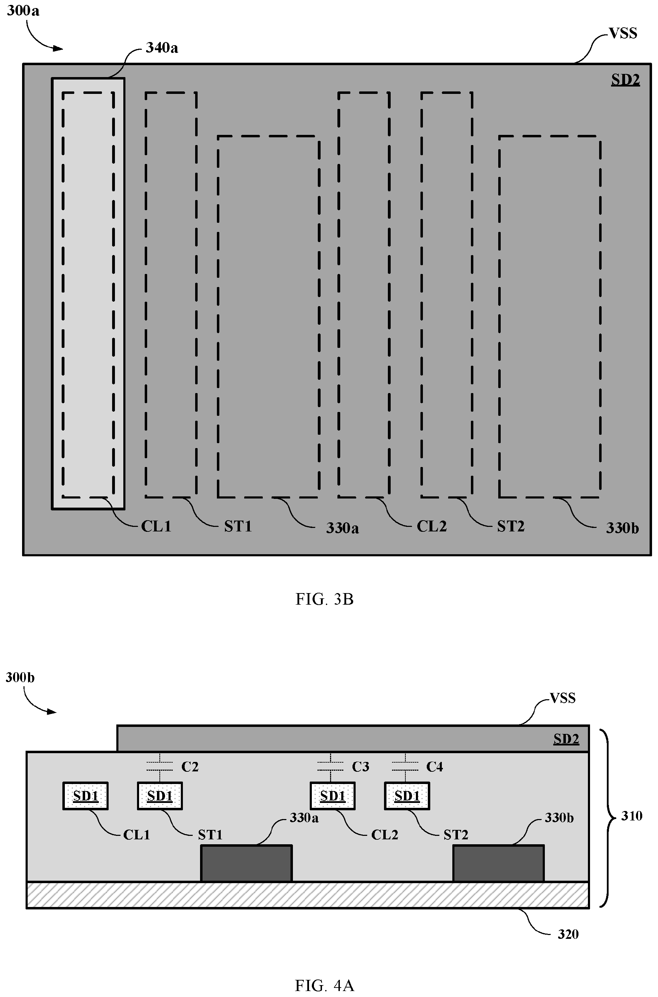

Referring to FIGs. 3A and 3B, a structure of a display panel according to an exemplary embodiment of the present disclosure is schematically illustrated, wherein FIG. 3A schematically illustrates a laminated structure of a portion of the display panel in the form of a cut-away view, and FIG. 3B schematically illustrates a top view of the portion of the display panel illustrated in FIG. 3A in the form of a plan view. As shown in FIG. 3A, the display panel 300a may include the laminated structure 310 including: a substrate 320; GOA circuits 330a, 330b; a clock signal line CL1 providing a clock signal for the GOA circuit 330a and a start signal line ST1 providing a start signal for the GOA circuit 330a, a clock signal line CL2 providing a clock signal for the GOA circuit 330b and a start signal line ST2 providing a start signal for the GOA circuit 330b; and a common ground network wiring VSS. The GOA circuits 330a, 330b may be arranged on the substrate 320, the clock signal lines CL1, CL2 and the start signal lines ST1, ST2 may be arranged in a first source/drain wiring layer SD1 located above the GOA circuits 330a, 330b, and the common ground network wiring VSS may be arranged in a second source/drain wiring layer SD2 adjacent to the first source/drain wiring layer SD1. It should be understood that, in the context of the present disclosure, the substrate 320 may be any suitable substrate known in the related art, it may be a rigid substrate (e.g., a glass substrate, etc.) or may be a flexible substrate (e.g., a resin substrate, a plastic substrate, etc.) for realizing a flexible display panel. In addition, the GOA circuits 330a, 330b may also be any suitable GOA circuit known in the related art, and the number of GOA circuits may be less or more. The present disclosure does not make any limitation on specific types or numbers of substrates and GOA circuits.

In the display panel 300a shown in FIG. 3A, the common ground network wiring VSS located in the second source/drain wiring layer SD2 may include an opening 340a. The opening 340a may be positioned above the clock signal line CL1. Referring to FIG. 3B in combination, an orthographic projection of the opening 340a onto the substrate 320 covers an orthographic projection of the clock signal line CL1 onto the substrate 320. That is, the orthographic projection of the common ground network wiring VSS onto the substrate 320 surrounds the orthographic projection of the clock signal line CL1 onto the substrate 320. Thus, in the display panel 300a, the orthographic projection of the common ground network wiring VSS onto the substrate 320 does not overlap with the orthographic projection of the clock signal line CL1 onto the substrate 320. In this way, the mutual capacitance C1 between the clock signal line CL1 and the common ground network wiring VSS is eliminated, so the power consumption of the GOA circuit 330a can be reduced, and the load of the common ground network wiring VSS can be reduced.

It should be understood that the opening 340a in the common ground network wiring VSS corresponding to the clock signal line CL1, as shown in FIGs. 3A and 3B, is merely illustrative, but not restrictive. Thus, it is also possible to implement openings in the common ground network wiring VSS corresponding to other time-varying signal wiring. For example, based on the teaching of the embodiment shown in FIGs. 3A and 3B, those skilled in the art can appreciate that: a similar opening may also be provided in the common ground network wiring VSS at a position corresponding to the clock signal line CL2, such that the orthographic projection of the common ground network wiring VSS onto the substrate 320 likewise surrounds the orthographic projection of the clock signal line CL2 onto the substrate 320, so as to thereby eliminate the mutual capacitance C3 between the clock signal line CL2 and the common ground network wiring VSS, so that the power consumption of the GOA circuit 330b can be reduced, and also the load of the common ground network wiring VSS can be further reduced.

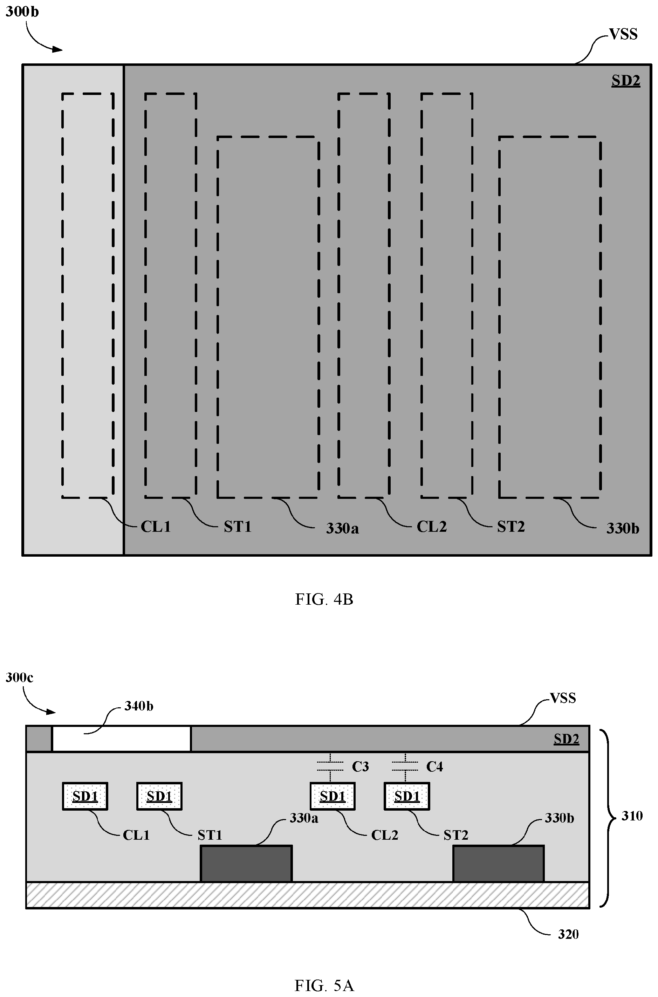

Referring to FIGs. 4A and 4B, a structure of a display panel according to another exemplary embodiment of the present disclosure is schematically illustrated, wherein FIG. 4A schematically illustrates a laminated structure of a portion of the display panel in the form of a cut-away view, and FIG. 4B schematically illustrates a top view of the portion of the display panel illustrated in FIG. 4A in the form of a plan view. It should be understood that the display panel 300b shown in FIGs. 4A and 4B is substantially identical in terms of structure compared to the display panel 300a shown in FIGs. 3A and 3B, only except that the common ground network wiring VSS in the second source/drain wiring layer SD2 has a different arrangement. Therefore, only this difference will be described hereinafter, and the same parts will not be repeatedly described.

As shown in FIGs. 4A and 4B, in the display panel 300b, the common ground network wiring VSS in the second source/drain wiring layer SD2 may be arranged such that an orthographic projection of the common ground network wiring VSS onto the substrate 320 and an orthographic projection of the clock signal line CL1 onto the substrate 320 are offset from each other, thereby also causing the orthographic projection of the common ground network wiring VSS onto the substrate 320 not to overlap with the orthographic projection of the clock signal line CL1 onto the substrate 320. It should be understood that the term "offset" in the context of the present disclosure refers to the situation that: the orthographic projection of the common ground network wiring VSS onto the substrate 320 does not overlap with the orthographic projection of the clock signal line CL1 onto the substrate 320, and the orthographic projection of the common ground network wiring VSS onto the substrate 320 does not surround the orthographic projection of the clock signal line CL1 onto the substrate 320 (as shown in FIG. 4B). Hereinafter, if not specifically stated, the term "offset" shall have the same meaning as described above. In this way, in the display panel 300b, the mutual capacitance C1 between the clock signal line CL1 and the common ground network wiring VSS is eliminated, thus the power consumption of the GOA circuit 330a can be reduced, and the load of the common ground network wiring VSS can also be reduced.

It should be understood that the offset arrangement of the common ground network wiring VSS with respect to the clock signal line CL1 shown in FIGs. 4A and 4B is merely illustrative, but not restrictive. Thus, an offset arrangement of the common ground network wiring VSS with respect to other time-varying signal wiring is also possible. For example, based on the teaching of the embodiment shown in FIGs. 4A and 4B, those skilled in the art can appreciate that: it is also possible to make the position of the common ground network wiring VSS offset from the position of the clock signal line CL2, so that the orthographic projection of the common ground network wiring VSS onto the substrate 320 and the orthographic projection of the clock signal line CL2 onto the substrate 320 are also offset from each other, and thereby the mutual capacitance C3 between the clock signal line CL2 and the common ground network wiring VSS can be eliminated, thus the power consumption of the GOA circuit 330b can be reduced, and the load of the common ground network wiring VSS can also be further reduced.

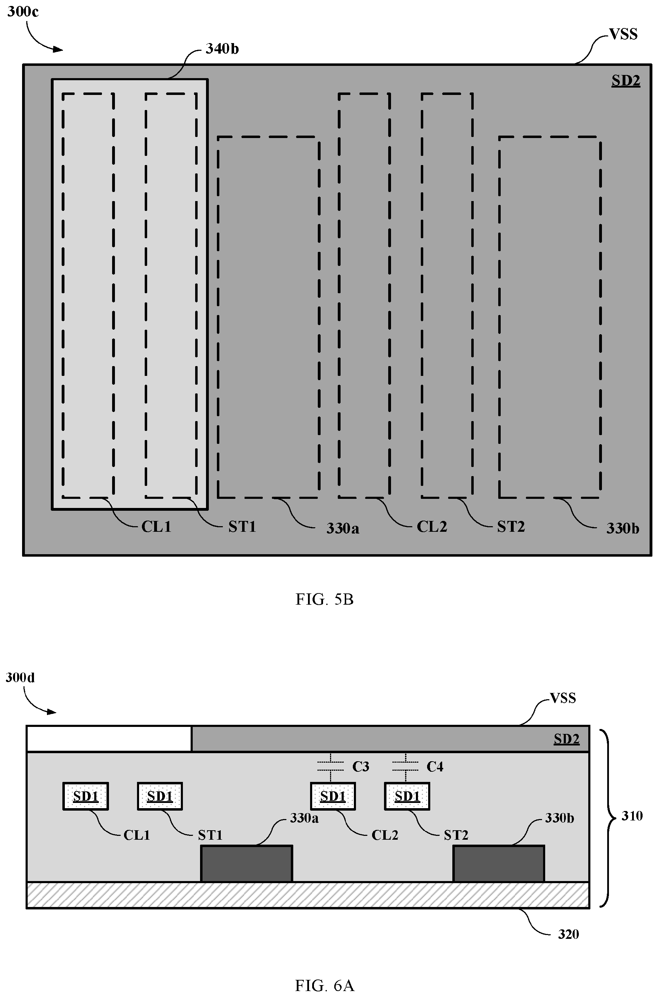

Referring to FIGs. 5A and 5B, a structure of a display panel according to another exemplary embodiment of the present disclosure is schematically illustrated, wherein FIG. 5A schematically illustrates a laminated structure of a portion of the display panel in the form of a cut-away view, and FIG. 5B schematically illustrates a top view of the portion of the display panel illustrated in FIG. 5A in the form of a plan view. It should be understood that the display panel 300c shown in FIGs. 5A and 5B is substantially identical in terms of structure compared to the display panel 300a shown in FIGs. 3A and 3B, only except that the common ground network wiring VSS in the second source/drain wiring layer SD2 have a different arrangement. Therefore, only this difference will be described hereinafter, and the same parts will not be repeatedly described.

As shown in FIG. 5A, in the display panel 300c, the common ground network wiring VSS located in the second source/drain wiring layer SD2 may include an opening 340b. The opening 340B may be located above both the clock signal line CL1 and the start signal line ST1. With combined reference to FIG. 5B, the orthographic projection of the opening 340b onto the substrate 320 covers the orthographic projections of both the clock signal line CL1 and the start signal line ST1 onto the substrate 320, that is to say, there is no common ground network wiring VSS above the wiring area of the clock signal line CL1 and the start signal line ST1 in the first source/drain wiring layer SD1. That is, the orthographic projection of the common ground network wiring VSS onto the substrate 320 surrounds the orthographic projections of both the clock signal line CL1 and the start signal line ST1 onto the substrate 320 such that the orthographic projection of the common ground network wiring VSS onto the substrate 320 does not overlap with the orthographic projections of both the clock signal line CL1 and the start signal line ST1 onto the substrate 320. Thus, the mutual capacitance C1 between the clock signal line CL1 and the common ground network wiring VSS and the mutual capacitance C2 between the start signal line ST1 and the common ground network wiring VSS are eliminated, so that the power consumption of the GOA circuit 330a can be reduced, and the load of the common ground network wiring VSS can be reduced

It should be understood that the opening in the common ground network wiring VSS shown in FIGs. 5A and 5B corresponding to both the clock signal line CL1 and the start signal line ST1 is merely illustrative, but not restrictive. Thus, it is also possible to implement openings in the common ground network wiring VSS corresponding to other time-varying signal wiring. For example, based on the teaching of the embodiment shown in FIGs. 5A and 5B, those skilled in the art can appreciate that: an similar opening may also be provided in the common ground network wiring VSS at a location corresponding to both the clock signal line CL2 and the start signal line ST2, so that the orthographic projection of the common ground network wiring VSS onto the substrate 320 likewise surrounds the orthographic projections of both the clock signal line CL2 and the start signal line ST2 onto the substrate 320, thereby, the mutual capacitance C3 between the clock signal line CL2 and the common ground network wiring VSS is eliminated, and the mutual capacitance C4 between the start signal line ST2 and the common ground network wiring VSS is eliminated, so that the power consumption of the GOA circuit 330b can also be reduced, and the load of the common ground network wiring VSS can also be further reduced.

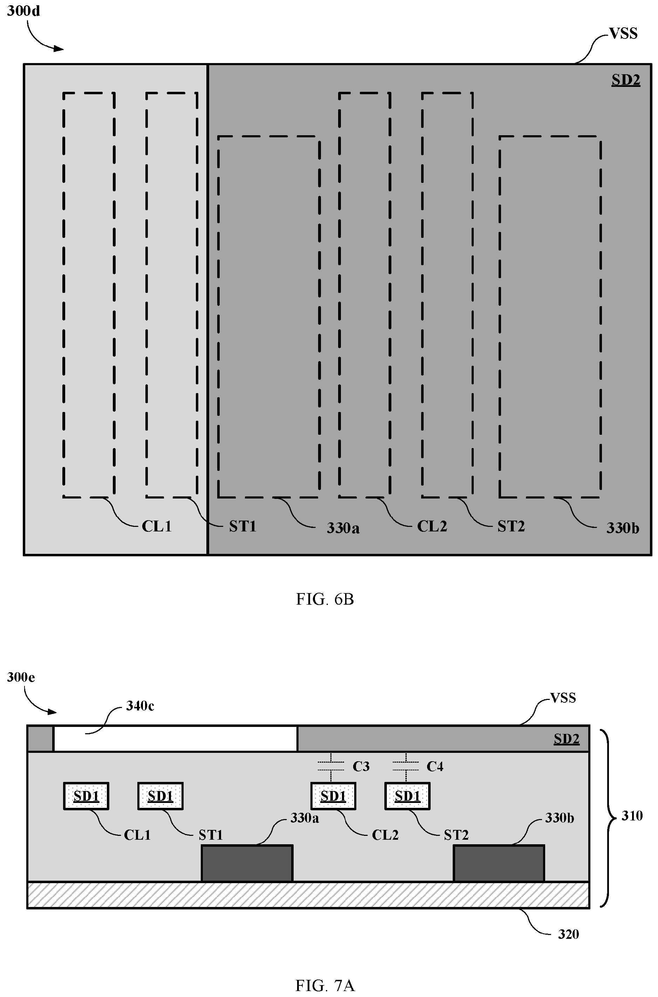

Referring to FIGs. 6A and 6B, a structure of a display panel according to another exemplary embodiment of the present disclosure is schematically illustrated, wherein FIG. 6A schematically illustrates a laminated structure of a portion of the display panel in the form of a cut-away view, and FIG. 6B schematically illustrates a top view of the portion of the display panel illustrated in FIG. 6A in the form of a plan view. It should be understood that the display panel 300d shown in FIGs. 6A and 6B is substantially identical in terms of structure compared to the display panel 300c shown in FIGs. 5A and 5B, except that the common ground network wiring VSS in the second source/drain wiring layer SD2 has a different arrangement. Therefore, only this difference will be described hereinafter, and the same parts will not be repeatedly described.

As shown in FIGs. 6A and 6B, in the display panel 300d, the common ground network wiring VSS in the second source/drain wiring layer SD2 may be arranged as making the orthographic projection of the common ground network wiring VSS onto the substrate 320 offset from the orthographic projections of the clock signal line CL1 and the start signal line ST1 onto the substrate 320, so that the orthographic projection of the common ground network wiring VSS onto the substrate 320 does not overlap with the orthographic projection of the clock signal line CL1 onto the substrate 320. In this way, in the display panel 300d, the mutual capacitance C1 between the clock signal line CL1 and the common ground network wiring VSS and the mutual capacitance C2 between the start signal line ST1 and the common ground network wiring VSS are all eliminated, thus the power consumption of the GOA circuit 330A can be reduced, and the load of the common ground network wiring VSS can also be reduced.

It should be understood that the offset arrangement of the common ground network wiring VSS relative to the clock signal line CL1 and the start signal line ST1 shown in FIGs. 6A and 6B is merely illustrative, but not restrictive. Thus, an offset arrangement of the common ground network wiring VSS relative to the other time-varying signal wiring is also possible. For example, based on the teaching of the embodiment shown in FIGs. 6A and 6B, those skilled in the art can appreciate that: the common ground network wiring VSS may also be offset from the corresponding positions of the clock signal line CL2 and the start signal line ST2, so that the orthographic projection of the common ground network wiring VSS onto the substrate 320 is also offset from the orthographic projections of the clock signal line CL2 and the start signal line ST2 onto the substrate 320, the mutual capacitance C3 between the clock signal line CL2 and the common ground network wiring VSS and the mutual capacitance C4 between the start signal line ST2 and the common ground network wiring VSS are thereby further eliminated, so that the power consumption of the GOA circuit 330b can also be reduced, and the load of the common ground network wiring VSS can also be further reduced.

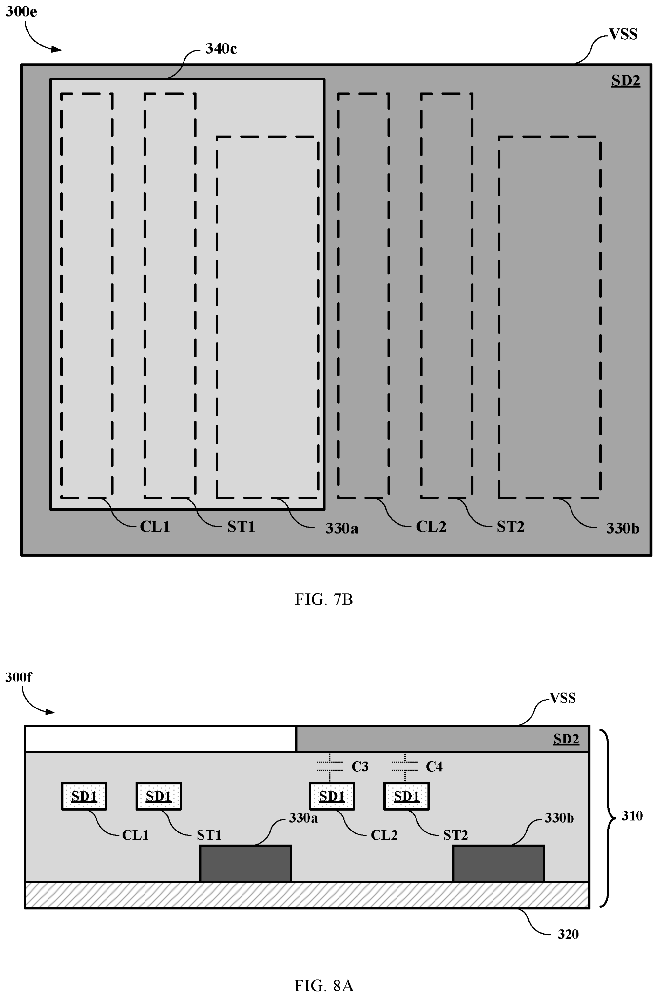

Referring to FIGS. 7A and 7B, a structure of a display panel according to another exemplary embodiment of the present disclosure is schematically illustrated, wherein FIG. 7A schematically illustrates a laminated structure of a portion of the display panel in the form of a cut-away view, and FIG. 7B schematically illustrates a top view of the portion of the display panel illustrated in FIG. 7A in the form of a plan view. It should be understood that the display panel 300e shown in FIGs. 7A and 7B is substantially identical in terms of structure to the display panel 300a shown in FIGs. 3A and 3B and the display panel 300c shown in FIGs. 5A and 5B, only except that the common ground network wiring VSS in the second source/drain wiring layer SD2 have a different arrangement. Therefore, only this difference will be described hereinafter, and the same parts will not be repeatedly described.

As shown in FIG. 7A, in the display panel 300e, the common ground network wiring VSS located in the second source/drain wiring layer SD2 may include an opening 340c. The opening 340c may be located above the clock signal line CL1, the start signal line ST1 and the GOA circuit 330a. Referring to FIG. 7B in combination, the orthographic projection of the opening 340c onto the substrate 320 covers orthographic projections of the clock signal line CL1, the start signal line ST1 and the GOA circuit 330a onto the substrate 320. That is, the orthographic projection of the common ground network wiring VSS onto the substrate 320 surrounds the orthographic projections of the clock signal line CL1, the start signal line ST1 and the GOA circuit 330a onto the substrate 320, so that the orthographic projection of the common ground network wiring VSS onto the substrate 320 does not overlap with the orthographic projections of the clock signal line CL1, the start signal line ST1 and the GOA circuit 330a onto the substrate 320. Thus, the mutual capacitance C1 between the clock signal line CL1 and the common ground network wiring VSS, the mutual capacitance C2 between the start signal line ST1 and the common ground network wiring VSS, and the mutual capacitance that may exist between the GOA circuit 330a and the common ground network wiring VSS are all eliminated, so that the power consumption of the GOA circuit 330a can be reduced, and the load of the common ground network wiring VSS can also be reduced.

It should be understood that the opening in the common ground network wiring VSS shown in FIGs. 7A and 7B corresponding to the clock signal line CL1, the start signal line ST1 and the GOA circuit 330a is merely illustrative, but not restrictive. Thus, it is also possible to implement an opening in the common ground network wiring VSS corresponding to other time-varying signal wiring. For example, based on the teaching of the embodiment shown in FIGs. 7A and 7B, those skilled in the art can appreciate that: a similar opening may also be provided in the common ground network wiring VSS at a position corresponding to the clock signal line CL2, the start signal line ST2 and the GOA circuit 330b, so that the orthographic projection of the common ground network wiring VSS onto the substrate 320 likewise surrounds the orthographic projections of the clock signal line CL2, the start signal line ST2 and the GOA circuit 330b onto the substrate 320, whereby the mutual capacitance C3 between the clock signal line CL2 and the common ground network wiring VSS, the mutual capacitance C4 between the start signal line ST2 and the common ground network wiring VSS, and the mutual capacitance that may exist between the GOA circuit 330b and the common ground network wiring VSS are eliminated, so that the power consumption of the GOA circuit 330b can also be reduced, and the load of the common ground network wiring VSS can be further reduced. In addition, it should also be understood that, in other embodiments, the orthographic projection of the common ground network wiring VSS onto the substrate 320 may also surround both the clock signal line CL1 and the GOA circuit 330a, and/or may surround both the clock signal line CL2 and the GOA circuit 330b.

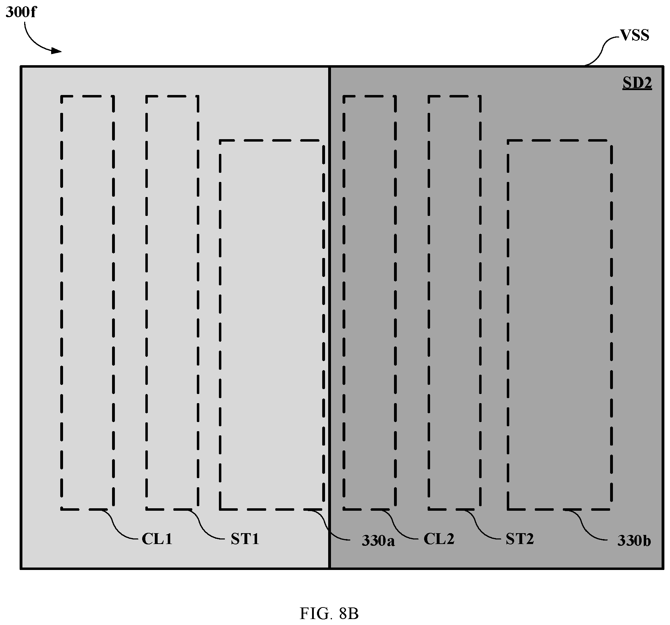

Referring to FIGs. 8A and 8B, a structure of a display panel according to another exemplary embodiment of the present disclosure is schematically illustrated, wherein FIG. 8A schematically illustrates a laminated structure of a portion of the display panel in the form of a cut-away view, and FIG. 8B schematically illustrates a top view of the portion of the display panel illustrated in FIG. 8A in the form of a plan view. It should be understood that the display panel 300f shown in FIGs. 8A and 8B is substantially identical in terms of structure to the display panel 300e shown in FIGs. 7A and 7B, only except that the common ground network wiring VSS in the second source/drain wiring layer SD2 has a different arrangement. Therefore, only this difference will be described hereinafter, and the same parts will not be repeatedly described.

As shown in FIGs. 8A and 8B, in the display panel 300f, the common ground network wiring VSS in the second source/drain wiring layer SD2 may be configured as: the orthographic projection of the common ground network wiring VSS onto the substrate 320 is offset from the orthographic projections of the clock signal line CL1, the start signal line ST1 and the GOA circuit 330a onto the substrate 320, so that the orthographic projection of the common ground network wiring VSS onto the substrate 320 does not overlap with the orthographic projection of the clock signal line CL1 onto the substrate 320. In this way, in the display panel 300f, the mutual capacitance C1 between the clock signal line CL1 and the common ground network wiring VSS, the mutual capacitance C2 between the start signal line ST1 and the common ground network wiring VSS, and the mutual capacitance that may exist between the GOA circuit 330a and the common ground network wiring VSS are all eliminated, so that the power consumption of the GOA circuit 330a can be reduced, and the load of the common ground network wiring VSS can also be reduced.

It should be understood that the offset arrangement of the common ground network wiring VSS relative to the clock signal line CL1, the start signal line ST1, and the GOA circuit 330a shown in FIGs. 8A and 8B is merely illustrative, but not restrictive. Thus, an offset arrangement of the common ground network wiring VSS relative to the other time-varying signal wiring is also possible. For example, based on the teaching of the embodiment shown in FIGs. 8A and 8B, those skilled in the art can appreciate that: it is also possible to make the common ground network wiring VSS offset from the corresponding positions of the clock signal line CL2, the start signal line ST2 and the GOA circuit 330b, so that the orthographic projection of the common ground network wiring VSS onto the substrate 320 is also offset from the orthographic projections of the clock signal line CL2, the start signal line ST2 and the GOA circuit 330b onto the substrate 320, and thereby the mutual capacitance C3 between the clock signal line CL2 and the common ground network wiring VSS, the mutual capacitance C4 between the start signal line ST2 and the common ground network wiring VSS, and the mutual capacitance that may exist between the GOA circuit 330b and the common ground network wiring VSS are all eliminated, thus, the power consumption of the GOA circuit 330b can also be reduced, and the load of the common ground network wiring VSS can also be further reduced.

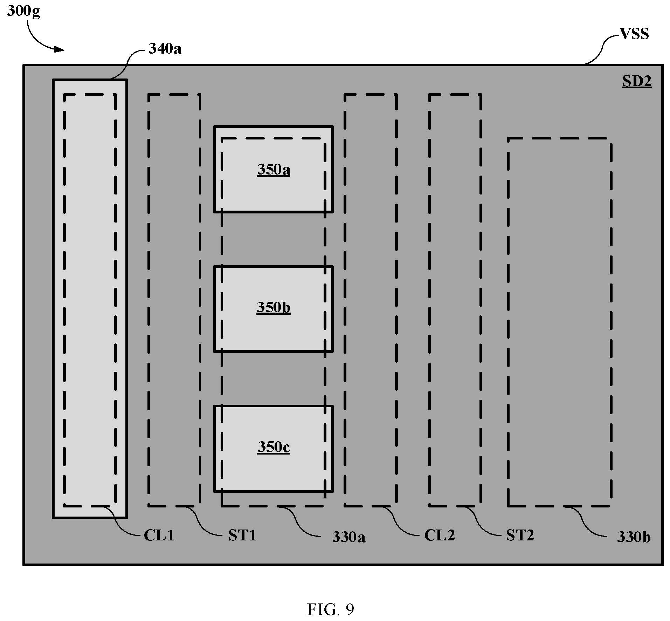

Referring to FIG. 9, a top view of a display panel according to another exemplary embodiment of the present disclosure is schematically illustrated in the form of a plan view. It should be understood that the display panel 300g shown in FIG. 9 is substantially identical in terms of structure to the display panel 300a shown in FIGs. 3A and 3B, only except that the common ground network wiring VSS in the second source/drain wiring layer SD2 further has a different arrangement. Therefore, only this difference will be described hereinafter, and the same parts will not be repeatedly described.

As shown in the plan view shown in FIG. 9, the orthographic projection of the common ground network wiring VSS onto the substrate 320 in the display panel 300g covers the orthographic projection of the GOA circuit 330a onto the substrate 320, wherein a portion of the common ground network wiring VSS corresponding to the GOA circuit 330a further includes a plurality of openings 350a, 350b and 350c, so that orthographic projections of the plurality of openings 350a, 350b and 350c onto the substrate 320 also overlap at least partially with the orthographic projection of the GOA circuit 330a onto the substrate 320. In this way, in the display panel 300g, the mutual capacitance C1 between the clock signal line CL1 and the common ground network wiring VSS is eliminated, the capacitance that may exist between the GOA circuit 330a and the common ground network wiring VSS is at least reduced, so that the power consumption of the GOA circuit 330a can be reduced, and the load of the common ground network wiring VSS can also be reduced.

It should be understood that the arrangement of the common ground network wiring VSS shown in FIG. 9 is merely illustrative, but not restrictive. Thus, it is also possible to implement openings in the common ground network wiring VSS corresponding to other time-varying signal wiring and/or circuit. For example, based on the teaching of the embodiment shown in FIG. 9, those skilled in the art can appreciate that the orthographic projection of the common ground network wiring VSS onto the substrate 320 may also cover the orthographic projections of other components (such as the start signal lines ST1 and ST2 and/or the GOA circuit 330b) in the display panel 300g onto the substrate 320, and portions of the common ground network wiring VSS overlapping with these orthographic projections can have a plurality of openings therein. In this way, the power consumption of the GOA circuit 330b can also be reduced, and the load of the common ground network wiring VSS can also be further reduced.

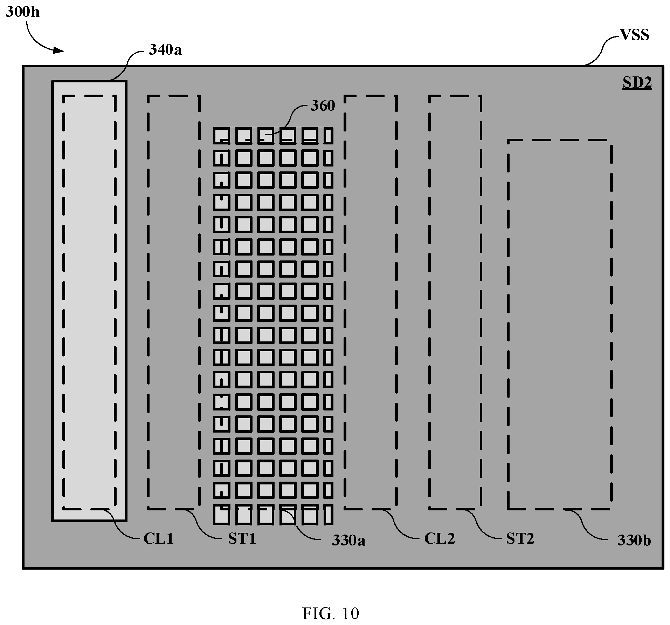

Referring to FIG. 10, a top view of a display panel according to another exemplary embodiment of the present disclosure is schematically illustrated in the form of a plan view. It should be understood that the display panel 300h shown in FIG. 10 is substantially identical in terms of structure to the display panel 300a shown in FIGs. 3A and 3B and the display panel 300g shown in FIG. 9, only except that the common ground network wiring VSS in the second source/drain wiring layer SD2 further has a different arrangement. Therefore, only this difference will be described hereinafter, and the same parts will not be repeatedly described.

As shown in the plan view shown in FIG. 10, the orthographic projection of the common ground network wiring VSS in the display panel 300h onto the substrate 320 covers the orthographic projection of the GOA circuit 330a onto the substrate 320, wherein a portion of the common ground network wiring VSS corresponding to the GOA circuit 330a has a mesh shape 360 therein, so that a portion of the orthographic projection of the common ground network wiring VSS onto the substrate 320 overlapping with the orthographic projection of the GOA circuit 330a onto the substrate 320 also has a mesh shape. In this way, in the display panel 300h, the mutual capacitance C1 between the clock signal line CL1 and the common ground network wiring VSS, and the mutual capacitance that may exist between the GOA circuit 330a and the common ground network wiring VSS are all eliminated or reduced, so that the power consumption of the GOA circuit 330a can be reduced, and the load of the common ground network wiring VSS can be reduced as well.

It should be understood that the arrangement of the common ground network wiring VSS shown in FIG. 10 is merely illustrative, but not restrictive. Thus, it is also possible to implement mesh structures in the common ground network wiring VSS and corresponding to other time-varying signal wiring and/or circuit. For example, based on the teaching of the embodiment shown in FIG. 10, a person skilled in the art can appreciate that the orthographic projection of the common ground network wiring VSS onto the substrate 320 may also cover the orthographic projections of other components such as the start signal lines ST1 and ST2 and/or the GOA circuit 330b onto the substrate 320 in the display panel 300h, and the portions of the common ground network wiring VSS overlapping with these orthographic projections may have a mesh shape. In this way, the power consumption of the GOA circuit 330b can also be reduced, and the load of the common ground network wiring VSS can also be further reduced.

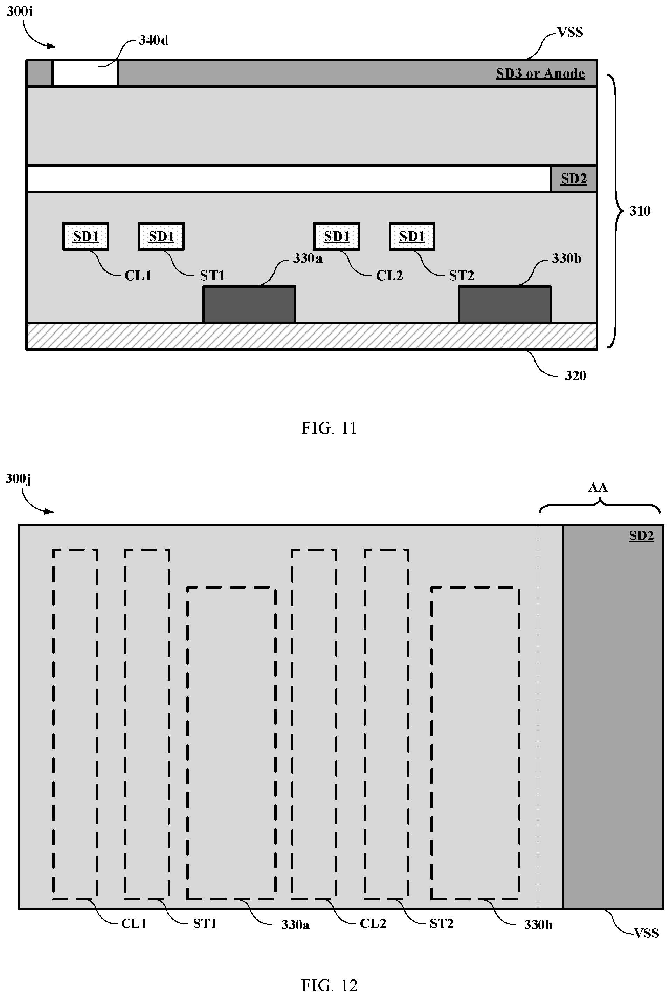

Referring to FIG. 11, a structure of a display panel according to another exemplary embodiment of the present disclosure is schematically illustrated. The display panel 300i shown in FIG. 11 is substantially identical in terms of structure to the display panel 300a shown in FIGs. 3A and 3B, only except that the common ground network wiring VSS also has a different arrangement. Therefore, only this difference will be described hereinafter, and the same parts will not be repeatedly described.

In the display panel 300i shown in FIG. 11, the film layer in which the common ground network wiring VSS is located is not adjacent to the film layer in which the clock signal line CL1 is located. That is, there is at least another metal wiring layer between the film layer in which the common ground network wiring VSS is located and the film layer in which the clock signal line CL1 is located. As shown in FIG. 11, the clock signal lines CL1, CL2 may be located in a first source/drain wiring layer SD1, while the common ground network wiring VSS may be located in a third source/drain wiring layer SD3 or anode wiring layer Anode, which is not adjacent to the first source/drain wiring layer SD1. Of course, an opening 340d located above and corresponding to the clock signal line CL1 may still be included in the common ground network wiring VSS. Thus, the mutual capacitance C1 between the clock signal line CL1 and the common ground network wiring VSS is eliminated. And due to the increase of the distance between the common ground network wiring VSS and the first source/drain wiring layer SD1, mutual capacitances such as those between the clock signal line CL2, the start signal lines ST1, ST2, the GOA circuits 330a, 3303b and the common ground network wiring VSS are significantly reduced, so that the power consumption of the GOA circuit 330a can be reduced, and the load of the common ground network wiring VSS can be reduced.

It should be understood that the common ground network wiring VSS shown in FIG. 11, which is located in the third source/drain wiring layer SD3 or the anode wiring layer Anode, is merely illustrative, but not restrictive. For example, based on the teaching of the embodiment shown in FIG. 11, those skilled in the art can appreciate that the common ground network wiring VSS can be arranged in any other film layer that is not adjacent to the first source/drain wiring layer SD1 in which the clock signal lines CL1, CL2 are located, so long as the distance between the common ground network wiring VSS and the first source/drain wiring layer SD1 can be increased.

Referring to FIG. 12, a structure of a display panel according to another exemplary embodiment of the present disclosure is schematically illustrated. The display panel 300j shown in FIG. 12 is substantially identical in terms of structure to the display panel 300f shown in FIGs. 8A and 8B, only except that the common ground network wiring VSS also has a different arrangement. Therefore, only this difference will be described hereinafter, and the same parts will not be repeatedly described.

In the display panel 300j shown in FIG. 12, the common ground network wiring VSS is arranged within the display area AA of the display panel 300j, and the clock signal lines CL1 and CL2, the start signal lines ST1 and ST2, and the GOA circuits 330a and 330b are all arranged outside the display area AA. In this way, the orthographic projection of the common ground network wiring VSS onto the substrate 320 is completely offset from the orthographic projections of the clock signal lines CL1 and CL2, the start signal lines ST1 and ST2, and the GOA circuits 330a and 330b onto the substrate 320. Therefore, the mutual capacitances between CL1 and CL2, the start signal lines ST1 and ST2, the GOA circuits 330a and 330b and the common ground network wiring VSS are all eliminated, so that the power consumption of the GOA circuits 330a and 330b can be reduced, and the load of the common ground network wiring VSS can be reduced.

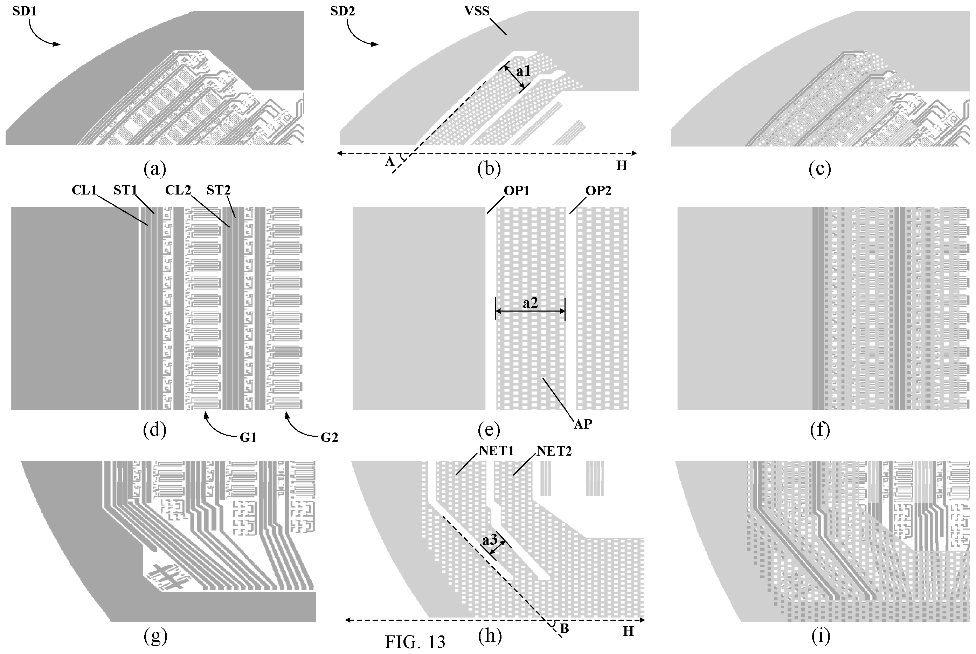

Referring to FIG. 13, the first source/drain wiring layer SD1, the common ground network wiring VSS located in the adjacent second source/drain wiring layer SD2, and the laminated structure of the two stacked together, in a display panel according to one exemplary embodiment of the present disclosure, are schematically illustrate in the form of exploded views. As shown in FIG. 13, views (a), (b) and (c) relate to an upper portion of the display panel, views (d), (e) and (f) relate to a middle portion of the display panel, and views (g), (h) and (i) relate to a lower portion of the display panel. It should be understood that views (a) through (i) merely illustrate the first source/drain wiring layer SD1, the common ground network wiring VSS in the adjacent second source/drain wiring layer SD2, and the stacking situation of both at some areas in the various portions of the display panel (i.e., the upper, middle, and lower portions of the display panel). However, this does not imply that the views (a), (b), and (c) concerning the upper portion of the display panel, the views (g), (h), and (i) concerning the lower portions of the display panel, necessarily align perfectly with the views (d), (e), and (f) concerning the middle portions of the display panel.

Views (a), (d) and (g) respectively show the first source/drain routing layer SD1 at the upper portion, the middle portion and the lower portion of the display panel, in which the corresponding clock signal lines CL1 and CL2, start signal lines ST1 and ST2, and GOA circuits G1 and G2 are included. The GOA circuits G1 and G2 each include a plurality of driving modules, and the clock signal line CL1 and the start signal line ST1 are used to provide corresponding signals to the GOA circuit G1, and the clock signal line CL2 and the start signal line ST2 are used to provide corresponding signals to the GOA circuit G2.

Views (b), (e) and (h) show the common ground network wiring VSS in the second source/drain wiring layer SD2 at the upper portion, the middle portion and the lower portion of the display panel, respectively. As shown in these views, the common ground network wiring VSS has therein an opening OP1 corresponding to the clock signal line CL1 and start signal line ST1, and an opening OP2 corresponding to the clock signal line CL2 and start signal line ST2, and the common ground network wiring VSS also has mesh-shaped covering portions NET1 and NET2 respectively corresponding to the GOA circuits G1 and G2. The mesh-shaped covering portions NET1 and NET2 corresponding to the GOA circuits G1 and G2 each include a plurality of exhaust ports AP. The size of the exhaust port AP is much smaller than that of the openings OP1 and OP2, so that its orthographic projection onto the substrate of the display panel does not surround the orthographic projection of the corresponding signal line and/or GOA circuit onto the substrate, which is different from the openings OP1, OP2. In addition, the exhaust port AP is mainly used to release moisture generated in the organic layers covering the GOA circuits G1 and G2, and is not mainly used to remove or reduce mutual capacitance between the common ground network wiring VSS and the corresponding signal lines and/or GOA circuits. As shown in view (b), in the upper portion of the display panel, the openings OP1 and OP2 may respectively have different shapes at their ends, to accommodate corresponding wirings of the clock signal line and start signal line in the first source/drain wiring layer SD1, so that after being stacked, an orthographic projection of the respective opening onto the substrate of the display panel can cover an orthographic projection of the corresponding wiring of the clock signal line or start signal line onto the substrate. Furthermore, as shown in view (h), in the lower portion of the display panel, the opening OP1 and the opening OP2 may be arranged to have different deflection angles with respect to the up-down extending direction of the display panel, so as to enable, in the laminated structure, the opening OP1 and the opening OP2 to cover the clock signal lines and the start signal lines deflected and extended at different angles. For example, the opening OP1 has an inclination angle A with respect to a first direction (e.g., a horizontal direction H shown with a dashed double-arrow line in the figure) in the upper portion of the display panel, and the opening OP1 has an inclination angle B with respect to the first direction (i.e., the horizontal direction H) in the lower portion of the display panel, wherein the inclination angle A is smaller than the inclination angle B, in other words, the opening OP1 is more inclined toward the display region (or pixel region) in the upper portion of the display panel than in the lower portion of the display panel. The opening OP2 also has the inclined arrangements similar to the inclined arrangements of the opening OP1 in the upper and lower portions of the display panel, and will not be repeatedly described here. Furthermore, as shown in views (b) and (e), in the upper and middle portions of the display panel, no exhaust port AP is provided in the side of the opening OP1 opposite to the mesh-shaped covering portion NET1, while as shown in view (h), in the lower portion of the display panel, the exhaust ports AP are also provided in the side of the opening OP1 opposite to the mesh-shaped covering portion NET1; however, for the opening OP2, in the upper portion, the middle portion and the lower portion of the display panel, both sides thereof are provided with exhaust ports AP. Furthermore, in the upper portion of the display panel, a plurality of exhaust ports AP are formed to be arranged substantially flush with the ends of the opening OP1 and the opening OP2, while in the lower portion of the display panel, a plurality of exhaust ports AP are formed to surround the portions of the opening OP1 and the opening OP2 in the lower portion.

Views (c), (f) and (i) show the first source/drain wiring layer SD1 and the common ground network wiring VSS in the second source/drain wiring layer SD2 stacked together at the upper, middle and lower portions of the display panel, respectively, wherein the opening OP1 in the common ground network wiring VSS at the upper, middle and lower portions of the display panel corresponds to the corresponding clock signal line CL1 and start signal line ST1 in the first source/drain wiring layer SD1, both the length and the width of the opening OP1 at respective portions are greater than the wiring ranges of the clock signal line CL1 and the start signal line ST1, so that in the laminated structure, the orthographic projection of the opening OP1 onto the substrate of the display panel can completely cover orthographic projections of the wiring of the clock signal line CL and the start signal line ST1 onto the substrate. The opening OP2 in the common ground network wiring VSS at the upper, middle and lower portions of the display panel correspond to the corresponding clock signal line CL2 and start signal line ST2 in the first source/drain wiring layer SD1, the length and width of the opening OP2 at respective portions are both greater than the wiring ranges of the clock signal line CL2 and the start signal line ST2, so that in the laminated structure, the orthographic projection of the opening OP2 onto the substrate of the display panel completely covers the orthographic projections of the clock signal line CL2 and the start signal line ST2 onto the substrate of the display panel. It can be seen clearly that the orthographic projection of the common ground network wiring VSS onto the substrate of the display panel surrounds the orthographic projections of the clock signal lines CL1, CL2 and the start signal lines ST1, ST2 onto the substrate of the display panel. Furthermore, the mesh-shaped covering portions NET1, NET2 having a mesh shape in the common ground network wiring VSS correspond to the GOA circuits G1 and G2 in the first source/drain wiring layer, respectively. The orthographic projection of the mesh-shaped covering portion NET1 onto the substrate of the display panel completely covers the orthographic projection of the GOA circuit G1 onto the substrate of the display panel, and the orthographic projection of the mesh-shaped covering portion NET2 onto the substrate of the display panel only partially covers the orthographic projection of the GOA circuit G2 onto the substrate of the display panel. Of course, according to actual needs, the orthographic projection of the mesh-shaped covering portion NET2 onto the substrate of the display panel can also completely cover the orthographic projection of the GOA circuit G2 onto the substrate of the display panel, and the orthographic projection of the mesh-shaped covering portion NET1 onto the substrate of the display panel may only partially cover the orthographic projection of the GOA circuit G1 onto the substrate of the display panel. As a result, the capacitance between the clock signal line and/or the start signal line and the common ground network wiring is eliminated, the capacitance between the GOA circuits and the common ground network wiring are reduced, thereby enabling the power consumption of the GOA circuit to be reduced, and enabling the load of the common ground network wiring to be also reduced.

With continued reference to views (a)-(i), in some embodiments, at least one of the opening OP1 and the opening OP2 is a continuous elongated opening at the upper, middle, and lower portions of the display panel (i.e., the opening is continuous without interruption, e.g., without interruption by portions of common ground network wiring). Therefore, the position to which the orthographic projection of the opening OP1 onto the substrate of the display panel corresponds completely covers the positions to which the orthographic projections of the clock signal line CL1 and the start signal line ST1 onto the substrate of the display panel correspond, the position to which the orthographic projection of the opening OP2 onto the substrate of the display panel corresponds completely covers the positions to which the orthographic projections of the clock signal line CL2 and the start signal line ST2 onto the substrate of the display panel correspond.

With continued reference to views (a)-(i), in some embodiments, the spacing distances between openings OP1 and OP2 at the upper, middle, and lower portions of the display panel may not be exactly the same. As shown in views (b), (e), (h): the spacing distance between the opening OP1 and the opening OP2 in the upper portion of the display panel is a1, the spacing distance between the opening OP1 and the opening OP2 in the middle portion of the display panel is a2, the spacing distance between the opening OP1 and the opening OP2 in the lower portion of the display panel is a3, wherein the relationship of the three spacing distances may be a1≥a2>a3, which thus helps to be suitable for the clock signal lines CL1, CL2 and the start signal lines ST1, ST2, etc. which are arranged.

It should be understood that, although in the exemplary embodiments described above with reference to FIGs. 3A to 13, the relative arrangements of the common ground network wiring relative to the clock signal lines and/or the start signal lines are described in detail, but in practice, in the laminated structure of a display panel, a mutual capacitance exists between any time-varying signal wiring and a DC constant signal wiring in an adjacent film layer, which adversely affects the power consumption of the display panel. It should be understood that in the context of the present disclosure, the term "time-varying signal" means a voltage of the signal varies over time, such as a clock signal in which the voltage of the signal repeatedly switches between a high level and a low level over time; whereas the term "DC constant signal" means a voltage of the signal remains constant over time, such as an electrical signal in a common ground network or in a supply network maintained at a certain voltage value.

Accordingly, in the embodiments provided according to the present disclosure, the display panel may include a substrate, a time-varying signal wiring arranged above the substrate, a DC constant signal wiring in a film layer adjacent to the time-varying signal wiring, wherein an orthographic projection of the DC constant signal wiring onto the substrate does not overlap with an orthographic projection of the time-varying signal wiring onto the substrate. In particular, in some exemplary embodiments, the orthographic projection of the DC constant signal wiring onto the substrate surrounds the orthographic projection of the time-varying signal wiring onto the substrate; in other exemplary embodiments, the orthographic projection of the DC constant signal wiring onto the substrate and the orthographic projection of the time-varying signal wiring onto the substrate are offset from each other. In this way, the mutual capacitance between the time-varying signal wiring and the DC constant signal wiring in the adjacent film layer can be reduced or even eliminated, thereby reducing the power consumption of the display panel.

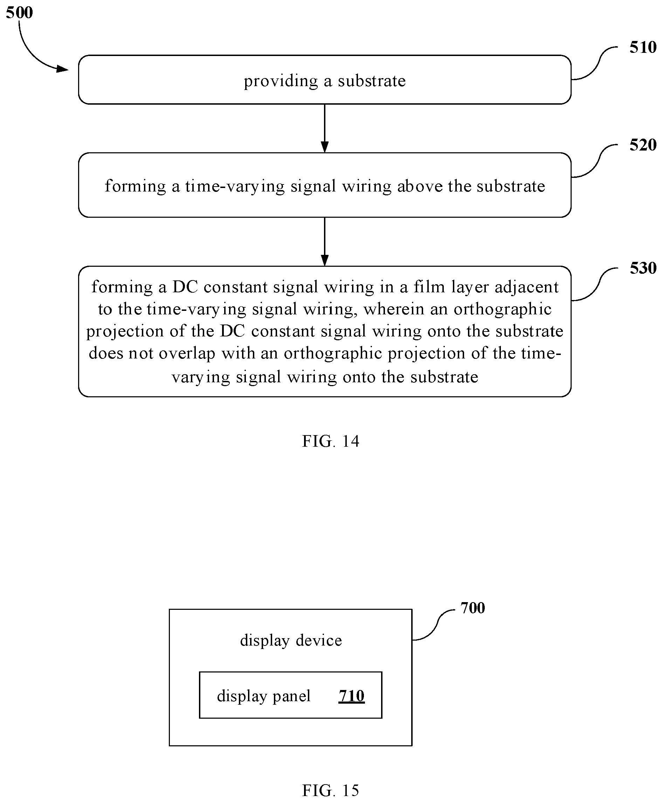

Referring to FIG. 14, a display panel manufacturing method according to an exemplary embodiment of the present disclosure is schematically illustrated in the form of a flowchart. As shown in FIG. 14, the display panel manufacturing method 500 includes the following steps:
at step 510, providing a substrate;
at step 520, forming a time-varying signal wiring above the substrate;
at step 530, forming a DC constant signal wiring in a film layer adjacent to the time-varying signal wiring, wherein an orthographic projection of the DC constant signal wiring onto the substrate does not overlap with an orthographic projection of the time-varying signal wiring onto the substrate.

Therefore, in a display panel manufactured by the display panel manufacturing method 500, the mutual capacitance between the time-varying signal wiring and the DC constant signal wiring in the adjacent film layer can be reduced or even eliminated, thereby reducing the power consumption of the display panel.

Furthermore, in some embodiments, the display panel manufacturing method 500 further includes: forming a GOA circuit on the substrate. Therefore, the time-varying signal wiring formed in above step 520 includes a clock signal line providing a clock signal for the GOA circuit, and the DC constant signal wiring formed in above step 530 includes a common ground network wiring. Thereby, the mutual capacitance between the clock signal line of the GOA circuit and the common ground network wiring is reduced or even eliminated, thus the power consumption of the GOA circuit can be reduced, and also the load of the common ground network wiring can be reduced.

Referring to FIG. 15, a display device according to an exemplary embodiment of the present disclosure is schematically illustrated in the form of a block diagram. As shown in FIG. 15, the display device 700 may include a display panel 710, wherein the display panel 710 may be implemented as any one of the display panels 300a to 300i, which have been described in detail above. Thereby, in the display device 700, the capacitance between the clock signal line and the common ground network wiring is eliminated, the capacitance between the GOA circuit and the common ground network wiring is reduced, thereby enabling the power consumption of the GOA circuit to be reduced, and enabling the load of the common ground network wiring to be reduced as well. In one embodiment, display device 700 may be implemented as an OLED display device. Furthermore, when implemented, the display device 700 provided according to the above exemplary embodiments of the present disclosure may be implemented as any product or component having a display function, such as a cellular phone, a tablet computer, a television set, a display, a notebook computer, a digital photo frame, a navigator, and the like. It should be understood that other essential components of the various display devices described above are known to those having ordinary skills in the art and will not be described in detail herein, nor should they be taken as a limitation on the present disclosure.

Terms used in the present disclosure are only used to describe embodiments in the present disclosure, and are not intended to limit the present disclosure. As used in the present disclosure, the singular forms "a," "an" and "the" are intended to include the plural forms as well, unless the context clearly indicates otherwise. It should be further understood that the terms "comprise", "include", "comprising" and "including", when used in the present disclosure, specify the presence of stated features, but do not preclude the presence or addition of one or more other features. As used in the present disclosure, the term "and/or" includes any and all combinations of one or more of the associated listed items. It should be understood that, although the terms "first", "second" and "third", etc. may be used in the present disclosure to describe various features, these features should not be limited by these terms. These terms are only used to distinguish one feature from another.

Unless otherwise defined, all terms (including technical terms and scientific terms) used in the present disclosure have the same meaning as commonly understood by one having ordinary skills in the art, to which the present disclosure belongs. It should be further understood that terms such as those defined in a common dictionary should be construed as having the same meaning as in the related art and/or in the context of the present specification, and will not be construed in an ideal or overly formal sense, unless defined explicitly as such in the present disclosure.

In the description of the Specification, expressions such as "one embodiment", "some embodiments", "an example", "a specific example", "some examples" or the like mean that a particular feature, structure, material or characteristic described in combination with the embodiment or example is included in at least an embodiment or example of the present disclosure. In this Specification, exemplary description of the above expressions is not necessarily directed to the same embodiment or example. Furthermore, the particular feature, structure, material, or characteristic as described may be combined in a suitable manner in any one or more embodiments or examples. Moreover, without contradicting each other and without violating the technical principles, different embodiments or examples and features of different embodiments or examples described in this Specification may be combined and assembled by a person skilled in the art, or some technical features may be omitted from different embodiments or examples described in this Specification, and embodiments or examples derived based on such combination, assembly or omission are still regarded as falling within the scope of the present disclosure.

The method described in the present disclosure includes one or more steps or actions. The steps and/or actions of the method do not have to be performed according to the order described in the present disclosure, but may be performed in a different order. For example, they may be performed simultaneously or in reverse order, as long as they do not contradict the principles of the solution described in the present disclosure. Furthermore, the steps or actions of the method described in the present disclosure may be replaced with different steps or actions, or additional steps or actions may also be included, according to practical needs.

Although the present disclosure has been described in detail in combination with some exemplary embodiments, it is not to be limited to the specific forms described in this disclosure. Rather, the scope of the present disclosure is defined only by the appended claims.

## Claims

1. A display panel, **characterized in that**, the display panel comprises a substrate, a time-varying signal wiring arranged above the substrate, a DC constant signal wiring in a film layer adjacent to the time-varying signal wiring, wherein an orthographic projection of the DC constant signal wiring onto the substrate does not overlap with an orthographic projection of the time-varying signal wiring onto the substrate.

2. The display panel according to claim 1, **characterized in that**, the orthographic projection of the DC constant signal wiring onto the substrate surrounds the orthographic projection of the time-varying signal wiring onto the substrate.

3. The display panel according to claim 1, **characterized in that**, the orthographic projection of the DC constant signal wiring onto the substrate and the orthographic projection of the time-varying signal wiring onto the substrate are offset from each other.

4. The display panel according to any one of claims 1 to 3, **characterized in that**, the display panel further comprises a GOA circuit arranged on the substrate, wherein the time-varying signal wiring comprises a clock signal line providing a clock signal for the GOA circuit, and the DC constant signal wiring comprises a common ground network wiring.

5. The display panel according to claim 4, **characterized in that**, the time-varying signal wiring further comprises a start signal line providing a start signal for the GOA circuit.

6. The display panel according to claim 4, **characterized in that**, an orthographic projection of the common ground network wiring onto the substrate does not overlap with an orthographic projection of the GOA circuit onto the substrate.

7. The display panel according to claim 6, **characterized in that**, the orthographic projection of the common ground network wiring onto the substrate also surrounds the orthographic projection of the GOA circuit onto the substrate.

8. The display panel according to claim 6, **characterized in that**, the orthographic projection of the common ground network wiring onto the substrate and the orthographic projection of the GOA circuit onto the substrate are also offset from each other.

9. The display panel according to claim 4, **characterized in that**, the orthographic projection of the common ground network wiring onto the substrate covers the orthographic projection of the GOA circuit onto the substrate, wherein a portion of the orthographic projection of the common ground network wiring onto the substrate overlapping with the orthographic projection of the GOA circuit onto the substrate comprises a plurality of openings.

10. The display panel according to claim 4, **characterized in that**, the orthographic projection of the common ground network wiring onto the substrate covers the orthographic projection of the GOA circuit onto the substrate, wherein a portion of the orthographic projection of the common ground network wiring onto the substrate overlapping with the orthographic projection of the GOA circuit onto the substrate has a mesh shape.

11. The display panel according to claim 4, **characterized in that**, an orthographic projection bit of the common ground network wiring onto the substrate is covered by an orthographic projection of a display area of the display panel onto the substrate, and orthographic projections of the clock signal line and the GOA circuit onto the substrate do not overlap with the orthographic projection of the display area onto the substrate.

12. The display panel according to claim 4, **characterized in that**, the DC constant signal wiring comprises a common ground network wiring, wherein at least one metal wiring film layer is further provided between a film layer where the common ground network wiring is located and a film layer where the time-varying signal wiring is located, and wherein an orthographic projection of the common ground network wiring onto the substrate does not overlap with an orthographic projection of the time-varying signal wiring onto the substrate.

13. A display panel manufacturing method, **characterized in that**, comprising:
providing a substrate;
forming a time-varying signal wiring above the substrate;
forming a DC constant signal wiring in a film layer adjacent to the time-varying signal wiring, wherein an orthographic projection of the DC constant signal wiring onto the substrate does not overlap with an orthographic projection of the time-varying signal wiring onto the substrate.

14. The display panel manufacturing method according to claim 13, **characterized in that**, further comprising: forming a GOA circuit on the substrate;
wherein the time-varying signal wiring comprises a clock signal line providing a clock signal for the GOA circuit, and the DC constant signal wiring comprises a common ground network wiring.

15. A display device, **characterized in that**, the display device comprises the display panel according to any one of claims 1 to 12.

16. The display device according to claim 15, **characterized in that**, the display device is an OLED display device.
